# EUROPÄISCHE PATENTSCHRIFT

(11) **EP 0 711 108 B1**
(45) Veröffentlichungstag und Bekanntmachung des Hinweises auf die Patenterteilung: **04.03.1998**
(21) Anmeldenummer: 93918919.7
(22) Anmeldetag: 26.08.1993
(51) Int. Cl.: A01B 1/00, B05C 11/08, B05C 9/12, H01L 21/00

(54) **VORRICHTUNG ZUR BELACKUNG VON SUBSTRATEN IN DER HALBLEITERFERTIGUNG**
DEVICE FOR COATING SUBSTRATES IN SEMICONDUCTOR MANUFACTURE
DISPOSITIF POUR LE VERNISSAGE DE SUBSTRATS DANS LA FABRICATION DE SEMI-CONDUCTEURS

(43) Veröffentlichungstag der Anmeldung: 15.05.1996
(73) Patentinhaber: STEAG MicroTech GmbH, 72124 Pliezhausen (DE)
(72) Erfinder: MÜHLFRIEDEL, Eberhard, D-75433 Maulbronn (DE); KALLIS, Martin, D-75417 Mühlacker (DE); APPICH, Karl, D-75447 Sternenfels (DE)
(86) Internationale Anmeldenummer: DE9300778
(87) Internationale Veröffentlichungsnummer: WO9505901

(56) Entgegenhaltungen:
- EP-A- 0 180 078
- GB-A- 2 098 510
- US-A- 2 046 596
- US-A- 5 199 990
- IBM TECHNICAL DISCLOSURE BULLETIN Bd. 32, Nr. 1 , Juni 1989 Seiten 311 - 313 XP33192 'upside-down resist coating of semiconductor wafers'
- IBM TECHNICAL DISCLOSURE BULLETIN Bd. 10, Nr. 5 , Oktober 1967 Seiten 528 - 529 C. J. KELLER 'ultrasonic fountain processor'
- PATENT ABSTRACTS OF JAPAN vol. 6, no. 155 (E-125)(1033) 17. August 1982 & JP,A,57 076 835 (NIPPON DENKI K.K.) 14. Mai 1982 siehe Zusammenfassung

## Beschreibung

Bei der Halbleiterfertigung ergibt sich häufig die Aufgabe, rechteckige oder runde Substrate mit einer gleichmäßigen Schicht aus Lack oder anderen zunächst flüssigen Medien, z.B. Farbfiltern oder speziellen Schutzschichten, zu versehen. Bei herkömmlichen Vorrichtungen werden dabei die Substrate horizontal, und mit der zu belackenden Fläche nach oben, auf einem Drehteller befestigt. Auf den Mittelpunkt des Substrats wird von oben über eine Düse eine bestimmte Menge des Lackes oder der Flüssigkeit aufgetropft. Danach wird der Drehteller in Bewegung gesetzt. Durch die Zentrifugalkraft wird die Flüssigkeit während der Drehbewegung auf dem Substrat verteilt. Ein großer Teil der Flüssigkeit wird dabei über den Rand der Platte weggeschleudert. Die erreichbare Gleichförmigkeit der Schichtdicke hängt von der Größe der Drehbeschleunigung und Drehgeschwindigkeit ab. Nachteilig hierbei ist, daß bis zu 95 % der verwendeten Lackmenge über den Rand des Substrats abgeschleudert werden. Dieser abgeschleuderte Lack kann nicht mehr verwendet werden und ist damit verloren.

Aus dem IBM Technical Disclosure Bulletin Band 32, Nr. 1, Juni 1989, Seiten 311 - 313 ist es auch bekannt, ein Substrat mit der zu beschichtenden Seite nach unten an einem Drehteller zu befestigen. Zur Belackung wird diese Seite zunächst in einen Tank mit Resist eingetaucht, anschließend in einer Schrägstellung von 5° abgetropft, und dann in einem Schleudertopf geschleudert. Dadurch kann - nach den Angaben dieser Literaturstelle - die Menge des abgeschleuderten Resist um ca. 70 % verringert werden. Jedoch ist die Vorrichtung kompliziert, da der Schleudertopf horizontal über den Tank mit dem Resist verschoben werden muß. Dabei ist eine Verunreinigung des Resist völlig unvermeidlich, so daß die Qualität der Belackung leidet.

Eine Verbesserung von Belackungs- und Beschichtungsvorgängen wurde auch bereits dadurch erreicht, daß die Flüssigkeit über eine sehr schmale, offene Rinne durch Kapillar- und Adhäsionseffekte auf eine nach unten weisende Oberfläche eines Substrats aufgebracht wird. Dies zeigt z.B. die US 2 046 596, bei der ein schmales Band aus Zelluloid (für die Herstellung von Filmen) über einen Kapillarspalt hinweg bewegt und dadurch mit einer Flüssigkeit beschichtet wird, die durch diesen Kapillarspalt von unten her zugeführt wird.

Derartige Vorrichtungen sind für die Belackung oder Beschichtung von verhältnismäßig großen Platten in der Dünnschichttechnologie, z.B. von LCD-Bildschirmen, gut geeignet. Die damit erreichbare Gleichmäßigkeit der Lackdicke ist jedoch für die Belackung von Substraten in der Fertigung hochintegrierter Schaltkreise nicht in allen Fällen ausreichend.

Eine Aufgabe der Erfindung wird deshalb darin gesehen, die bekannten Belackungs- und Beschichtungsvorrichtungen im Hinblick auf die vorgenannten Kriterien zu verbessern.

Nach der Erfindung wird diese Aufgabe gelöst durch eine Vorrichtung zur Belackung eines Substrats mit einer Lackschicht, mit einem Drehteller, dem ein Antriebsmotor zugeordnet ist, und an welchem das Substrat mit der zu belackenden Oberfläche nach unten befestigbar ist, mit einer Vorbelackungsstation, welche einen mit Lack gespeisten Kapillarspalt aufweist, über dessen Oberseite das Substrat mit seiner zu belackenden Oberfläche mittels einer zur linearen Fortbewegung des Drehtellers dienenden Lineartransporteinheit hinweg bewegbar ist, um diese Oberfläche mit Lack aus dem Kapillarspalt vorzubelacken, und mit einer Schleuderstation, zu welcher der Drehteller nach der Vorbelackung durch die Lineartransporteinheit bewegbar ist, um dort die Lackschichtdicke durch Drehung des Drehtellers zu vergleichmäßigen und zu verringern. Der Lack wird also zunächst über den Kapillarspalt auf das Substrat aufgebracht. Anschließend wird das Substrat, ebenfalls mit der belackten Oberfläche nach unten, mit einer geeigneten Drehgeschwindigkeit geschleudert. Dabei wirkt auf die Lackschicht die Zentrifugalkraft, also eine nach außen gerichtete Verdrängungskraft. Naturgemäß muß sich in der Lackschicht ein Gleichgewicht aus Verdrängungs- und Adhäsionskraft einstellen. Die Bereiche des Lackes, deren Adhäsion an die Substratoberfläche bzw. an die darunterliegenden Lackschichten zu klein ist, werden zum Substratrand hin verdrängt, und ein Teil davon wird über den Rand hinausgeschleudert. Dadurch wird die Lackschichtdicke über die Substratoberfläche vereinheitlicht und insgesamt verringert. Die Halterung an einer Lineartransporteinheit ermöglicht den Transport des Substrats zwischen den Behandlungsstationen und auch die bei der Vorbelackung notwendige gleichförmige Bewegung des Substrats über den Kapillarspalt hinweg.

Vorteilhaft ist es, gemäß Anspruch 3 in der Schleuderstation einen Schutzring um das rotierende Substrat anzuordnen. Darin wird der Lack, der über den Substratrand hinausgeschleudert wird, aufgefangen und gezielt abgeleitet.

Eine weitere vorteilhafte Ausbildung der Erfindung ist dadurch gekennzeichnet, daß der Schutzring heb- und senkbar ausgebildet ist, um die Bewegung des Substrats durch die Lineartransporteinheit zu ermöglichen. Dadurch kann das Substrat ungehindert in horizontaler Richtung von der Vorbelackungsstation zur Schleuderstation transportiert werden. Hat das Substrat die letztere Station erreicht, so wird der Schutzring von unten auf Substrathöhe gefahren, um seine Funktion während des Schleudervorgangs zu übernehmen.

Auch wird die erfindungsgemäße Vorrichtung sehr vorteilhaft mit einer automatischen Be- und Entladevorrichtung versehen, so daß der gesamte Belackungsprozeß automatisiert werden kann. Dies ermöglicht gleichmäßige und reproduzierbare Belackungsergebnisse über große Stückzahlen.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den übrigen Unteransprüchen. Es zeigt:
- Fig. 1:: eine Ansicht des Gesamtaufbaus einer erfindungsgemäßen Belackungs- und Beschichtungsvorrichtung
- Fig. 2:: eine Ansicht der Vorrichtung zur Vorbelackung als Teil der Vorrichtung nach Fig. 1
- Fig. 3:: eine Ansicht der Schleuderstation als Teil der Vorrichtung nach Fig. 2

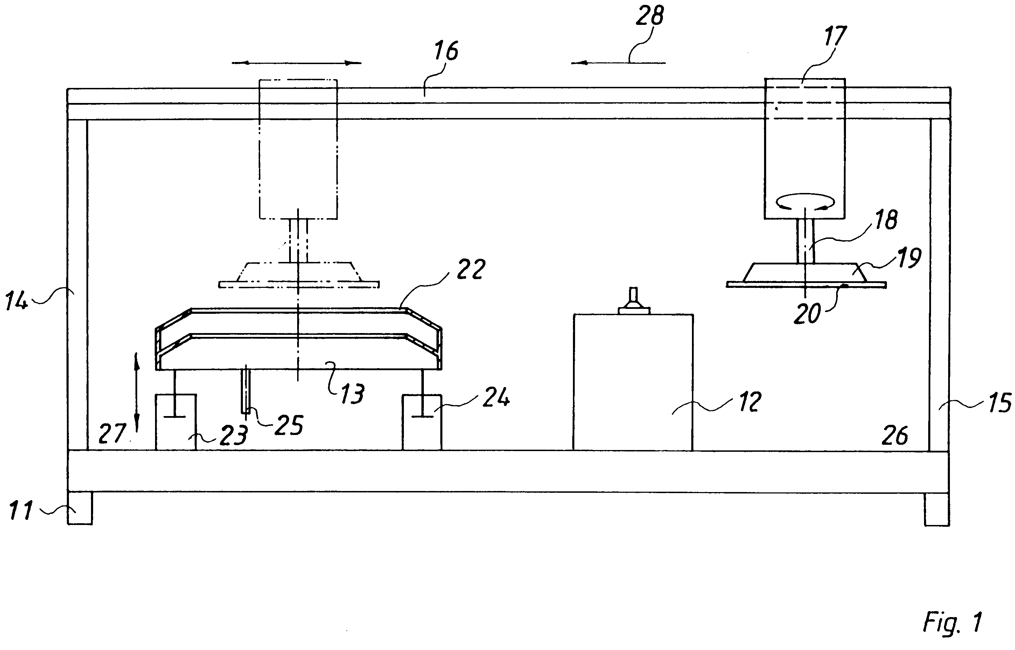

Fig. 1 zeigt ein erstes Ausführungsbeispiel einer erfindungsgemäßen Beschichtungsvorrichtung 10. Auf dem Gestell 11 sind sowohl die Rinne für die Vorbelackung 12 und der Schutzring der Schleuderstation 13 als auch die Ständer 14 und 15 für die Lineartransporteinheit 16 befestigt. An dem beweglichen Teil der Lineartransporteinheit 16 ist der Drehmotor 17 befestigt und an dessen Welle 18 der Drehtelller 19. Das Substrat 20 wird z. B. durch Vakuum an der Plattenhaltevorrichtung 19 festgesaugt. Dazu hat die Haltevorrichtung 19 entsprechende nicht dargestellte Vakuumbohrungen. Im Rahmen der Erfindung können aber auch andere Haltevorrichtungen verwendet werden, wie sie dem Fachmann bekannt sind.

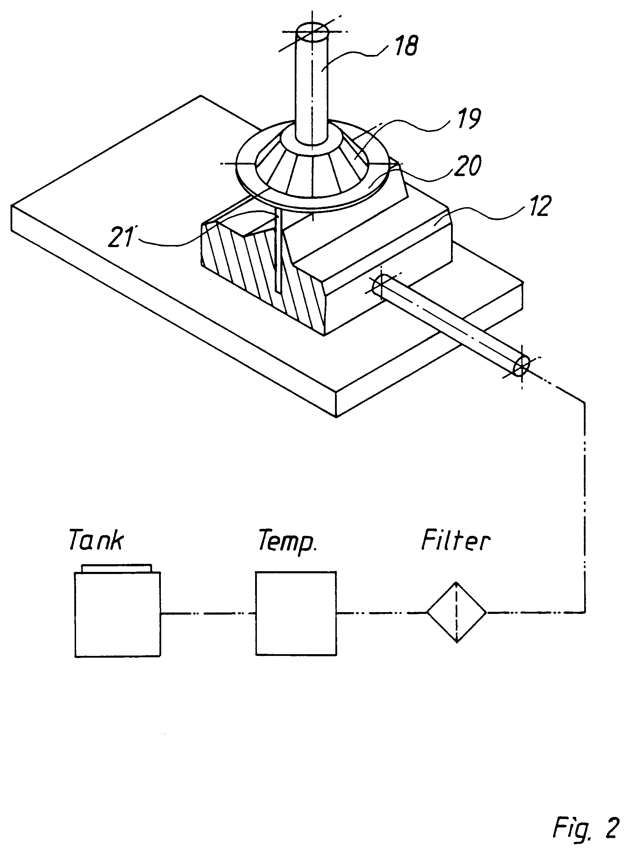

Die offene Rinne 12 mit dem Kapillarspalt 21 für die Vorbelackung ist in Fig. 1 im Schnitt und in Fig. 2 in perspektivischer Darstellung ebenfalls im Schnitt dargestellt.

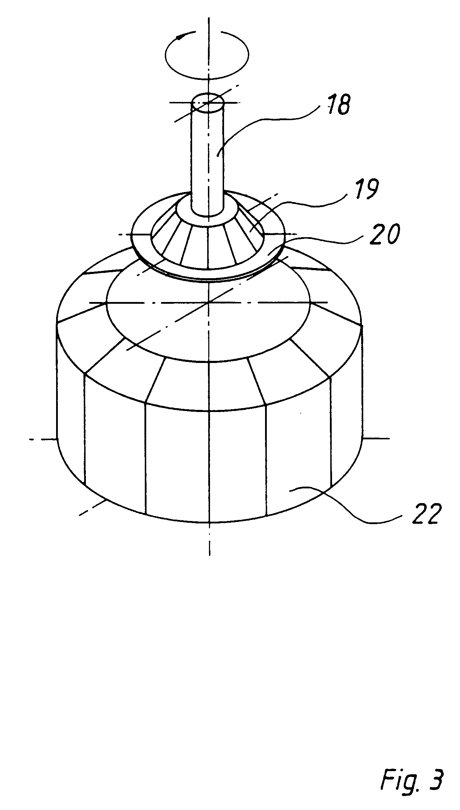

Neben der Vorbelackungsvorrichtung ist der Schutzring 22 für den Schleudervorgang angeordnet. Er ist auf einem oder mehreren Ständern 23 und 24 befestigt, die selbsttätig die Höhenposition des Schutzringes einstellen können. Dies können beispielsweise pneumatisch verstellbare Einheiten sein, aber auch andere Vorrichtungen, wie sie dem Fachmann bekannt sind. Für den Schleudervorgang wird der Schutzring 22 über den bzw. die Ständer 23 und 24 senkrecht nach oben gefahren bis er das Substrat in geeigneter Weise umschließt. In Fig. 3 ist das zu belackende Substrat an dem Drehteller 19 und der Motorwelle 18 oberhalb des Schutzringes 22 dargestellt. Dieselbe Darstellung ist in Fig. 1 mit Strichlinien angedeutet. Dies entspricht der Situation vor oder nach dem Schleudervorgang, in der sich das Substrat in der für den Schleudervorgang vorgesehenen Position an der Lineartransporteinheit 16 befindet, der Schutzring jedoch noch nicht nach oben gefahren oder bereits wieder nach unten gefahren wurde. Diese Auf- und Abbewegung des Schutringes 22 ist notwendig, damit er dem Substrat während dessen horizontalen Transportes an der Lineareinheit 16 nicht im Weg ist.

In Fig. 1 ist der Schutzring 22 aufgeschnitten dargestellt. Sein Querschnitt besteht aus einem angeschrägten U-Profil. Dies stellt sicher, daß der über den Rand des Substrates abgeschleuderte Lack sicher in dem Ringprofil aufgefangen und zum unteren inneren Rand des Schutzringes geleitet wird, von wo er über einen Lackablauf (25) vollständig entsorgt werden kann.

Für eine vollautomatisierte Version der Belackungsvorrichtung wird in dem in Fig. 1 mit 26 gekennzeichneten Bereich eine automatische Beladevorrichtung und in dem mit 27 gekennzeichneten Bereich eine automatische Entladevorrichtung montiert. Die Beladevorrichtung entnimmt das zu belackende Substrat 20 einem an einer bestimmten Stelle aufgesetzten Magazin und führt es der Plattenhaltevorrichtung 19 zu. Die Entladevorrichtung übernimmt das Substrat 20 von der Haltevorrichtung 19 und lädt es wiederum in ein an einer bestimmten Stelle aufgesetztes Magazin.

### Arbeitsweise der Belackungsvorrichtung:

Zunächst wird ein Substrat 20 entweder automatisch oder manuell an dem Drehteller 19 befestigt. Der Drehteller befindet sich zu diesem Zeitpunkt in dem Bereich, der in Fig. 1 mit 26 gekennzeichnet ist. Danach setzt sich die Lineartransporteinheit 16 in Richtung des mit 28 gekennzeichneten Pfeiles, also in Richtung auf die Rinne 12, in Bewegung.

Sobald der vorderste Punkt des Substrates die Oberkante des Kapillarspaltes 21 erreicht hat, beginnt die Vorbelackung. Naturgemäß wird das Substrat 20 während dieser Vorbelackung über den Kapillarspalt 21 in der Rinne 12 hinwegbewegt.

Nach Abschluß der Vorbelackung wird das Substrat 20 mit Drehteller 19 und Motor 17 samt Welle 18 weiter in Richtung des Pfeiles 28 transportiert bis es sich genau zentrisch oberhalb des in Wartestellung stehenden Schutzringes 22 befindet. Ist diese Position erreicht, wird der Schutzring 22 hochgefahren, bis er das Substrat 20 in geeigneter Weise umschließt. Danach beginnt der Schleudervorgang, durch den die Lackschichtdicke auf dem Substrat vergleichmäßigt und verringert wird. Der überschüssige Lack wird in den Schutzring 22 geschleudert und von dort über den Lackablauf 25 abgeleitet.

Nach Abschluß des Schleudervorganges fährt der Schutzring 22 wieder nach unten. Danach wird das Substrat 20 über die Transporteinheit 16 weiter bis zu dem in Fig. 1 mit 27 bezeichneten Bereich transportiert, wo es automatisch oder manuell von dem Drehteller 19 gelöst wird.

## Patentansprüche

1. Vorrichtung zur Belackung eines Substrats mit einer Lackschicht,
mit einem Drehteller (19), dem ein Antriebsmotor (18) zugeordnet ist, und an welchem das Substrat (20) mit der zu belackenden Oberfläche nach unten befestigbar ist,
mit einer Vorbelackungsstation (12), welche einen mit Lack gespeisten Kapillarspalt (21) aufweist, über dessen Oberseite das Substrat (20) mit seiner zu belackenden Oberfläche mittels einer zur linearen Fortbewegung des Drehtellers (19) dienenden Lineartransporteinheit (16) hinwegbewegbar ist, um diese Oberfläche mit Lack aus dem Kapillarspalt (21) vorzubelacken,
und mit einer Schleuderstation (22), zu welcher der Drehteller (19) nach der Vorbelackung durch die Lineartransporteinheit (16) bewegbar ist, um dort die Lackschichtdicke durch Drehung des Drehtellers (19) zu vergleichmäßigen und zu verringern.

2. Vorrichtung nach Anspruch 1, bei welcher die Bearbeitungsstationen für die Vorbelackung und für den Schleudervorgang nebeneinander angeordnet sind.

3. Vorrichtung nach Anspruch 1 oder 2, bei welcher die Schleuderstation einen Schutzring (22) mit einem angeschrägten U-Profil-Querschnitt aufweist, welcher beim Schleudern das rotierende Substrat (20) umgibt.

4. Vorrichtung nach Anspruch 3, bei welcher der Schutzring (22) heb- und senkbar ausgebildet ist, um die Bewegung des Substrats (20) durch die Lineartransporteinheit (16) zu ermöglichen.

5. Vorrichtung nach einem oder mehreren der vorhergehenden Ansprüche, bei welcher eine Beladestation (26) für die automatische Beladung des Drehtellers (19) vorgesehen ist.

6. Vorrichtung nach einem oder mehreren der vorhergehenden Ansprüche, bei welcher eine Entladestation (27) für die automatische Entladung des Drehtellers (19) vorgesehen ist.

## Claims

1. Device for lacquering a substrate with a lacquer coating, comprising a turntable (19) which is associated with a drive motor (18) and to which the substrate (20) is fastenable with the surface to be lacquered downwards, a pre-lacquering station (12) which has a capillary gap (21), across the upper side of which the substrate (20) is movable by its surface to be lacquered by means of a linear transport unit serving for the linear advance of the turntable (19) in order to pre-lacquer this surface with lacquer from the capillary gap (21), and a centrifuging station (22) to which the turntable (19) is movable by the linear transport unit (16) after the pre-lacquering in order to make uniform and reduce the lacquer coating thickness there by rotation of the turntable (19).

2. Device according to claim 1, in which the processing station, for the pre-lacquering and for the centrifuging procedure are arranged adjacent to one another.

3. Device according to claim 1 or 2, in which the centrifuging station has a protective ring (22) with a chamfered U-profile cross-section, which surrounds the rotating substrate (20) during the centrifuging.

4. Device according to claim 3, in which the protective ring (22) is constructed to be raisable and lowerable so as to enable the movement of the substrate (20) by the linear transport unit (16).

5. Device according to one or more of the preceding claims, in which a loading station (26) for the automatic loading of the turntable (19) is provided.

6. Device according to one or more of the preceding claims, in which an unloading station (27) for the automatic unloading of the turntable (19) is provided.

## Revendications

1. Dispositif pour laquer un support avec une couche de la que, avec un plateau tournant (19) auquel est associé un moteur d'entraînement (18) et sur lequel le support (20) peut être fixé avec la surface à laquer vers le bas,
avec une station de laquage préalable (12) qui présente une fente capillaire (21) alimentée en laque, sur le côté supérieur de laquelle le support (20) peut être amené à passer avec sa surface à laquer, au moyen d'une unité de transport linéaire destinée au déplacement linéaire du plateau tournant (19) pour laquer préalablement cette surface avec la laque de la fente capillaire (21),
et avec une station centrifuge (22) vers laquelle le plateau tournant (19), après le laquage préalable, peut être déplacé par l'unité de transport linéaire (16) pour y rendre uniforme et diminuer l'épaisseur de la couche de laque en faisant tourner le plateau tournant (19).

2. Dispositif selon la revendication 1, où les stations de traitement pour le laquage préalable et pour l'opération de centrifugation sont disposées l'une à côté de l'autre.

3. Dispositif selon la revendication 1 ou 2, où la station centrifuge présente une bague de protection (22) avec une section transversale biseautée d'un profil en U qui entoure lors de la centrifugation le support tournant (20).

4. Dispositif selon la revendication 3, où la bague de protection (22) est réalisée pour pouvoir être relevée et abaissée pour permettre le déplacement du support (20) à travers l'unité de transport linéaire (16).

5. Dispositif selon l'une ou plusieurs des revendications précédentes, où il est prévu une station de chargement (26) pour le chargement automatique du plateau tournant (19).

6. Dispositif selon l'une ou plusieurs des revendications précédentes où une station de déchargement (27) est prévue pour le déchargement automatique du plateau tournant (19).
